# EUROPEAN PATENT APPLICATION

(11) **EP 4 442 853 A1**
(43) Date of publication of application: **09.10.2024**
(21) Application number: 23460010.4
(22) Date of filing: 03.04.2023
(51) Int. Cl.: C23C 14/34, H01J 37/34

(54) **METHOD OF OPERATING A PLASMA PROCESS SYSTEM AND A PLASMA PROCESS SYSTEM**

(71) Applicant: TRUMPF Huettinger Sp. Z o. o., 05-220 Zielonka (PL)
(72) Inventor: The designation of the inventor has not yet been filed
(74) Representative: Trumpf Patentabteilung

(57) **Abstract**

Method of operating a plasma process system (1),
the plasma process system (1) comprises:
d) a plasma process chamber (2) with a plasma process chamber wall (3) being connected to an electrical potential, e. g. ground,
e) a HiPIMS power supply (4) designed for supplying high voltage high power pulses,
f) an electrode (5) inside the plasma chamber (2) connected to the HiPIMS power supply (4),
the method of operating a plasma process system (1) comprising the steps:
iv. the HiPIMS power supply (4) supplying pulses of high voltage with a first potential, in particular a negative potential, in relation to the plasma process chamber wall (3) to the electrode (5), and disconnecting in pulse off times (t_{off}),
v. the electrode is connected to a second potential opposite of the first potential, in particular a positive potential, in relation to the plasma process chamber wall (3) immediately before the pulses of high voltage with first potential.

## Description

The present invention relates to a method of operating a plasma process system and a plasma process system.

A plasma process system may be, for example, a system in which electrical power is supplied to a load, such as a plasma process arrangement.

Such a plasma process arrangement may be, for example, a plasma process chamber used for industrial plasma processes such as surface treatment of workpieces, semiconductor fabrication with plasma, or processing of workpieces with gas lasers.

In such an application, the plasma process arrangement is used to generate plasma.

To be able to generate plasma, a plasma process arrangement, e. g. a plasma process chamber, can have one or more electrodes. These electrodes can be designed as targets acting as cathodes, which can be connected to an electrical potential, especially negative electrical potential, of a DC power supply. The wall of the plasma chamber usually serves as an anode and is also connected to an electrical potential, especially ground potential.

This results in a potential difference between the target and the wall of the plasma process chamber. This potential difference is called the cathode voltage and is used to generate plasma.

The targets acting as cathodes may also have magnets that can enhance plasma generation. A power supply that has additional magnets on its acting cathode is then called a magnetron.

Target atoms are released from the target in plasma processes, which can then be used to coat a substrate located in the plasma process chamber, for example. The substrate can be connected to the wall of the plasma process chamber.

In common plasma generation processes, the DC power supply may provide power in the form of DC pulses. Characteristic of these DC pulses is that a high negative voltage is applied for a very short period of time and the DC pulses are repeated in defined time intervals. Between the DC pulses, the so-called pulse off time, the target acting as cathode is floating.

Such plasma generation techniques are called HiPIMS (high power impulse magnetron sputtering), which require suitable HiPIMS power supplies.

Such HiPIMS power supplies are disclosed and described in more detail in the following publication, e.g.: WO 2013/000918 A1.

Characteristics of HiPIMS include short pulses of a few micro- or milliseconds, a short duty cycle (on-off ratio) < 10% and the high degree of ionization of the released target atoms. The average power here is very similar to conventional DC sputtering processes in which no pulses are used. The power of the pulses may be equal or larger than 10 kW, in particular equal or larger than 100 kW. In addition, a bias voltage may be applied to the substrate in such processes. A bias voltage can be a voltage related to the wall of the plasma processing chamber, in particular negative voltage, for which another DC power supply can be used, but which does not have to provide pulses.

The bias voltage can be used to influence the energy and movement direction of the ionized target atoms impinging on the substrate.

In plasma process systems that have more than one targets acting as cathodes, the plasma can be active for the entire time of a process. Together with the operational periods when the target is floating, this leads to the accumulation of charged particles of the plasma on the target. These charged particles can change the potential of the target and thus cause arcs. These arcs can damage the plasma process chamber itself and everything in the plasma process chamber.

The present invention is therefore based on the task of providing a method of operating a plasma process system which mitigates arcing in a plasma process chamber.

This task is solved by the method of operating a plasma process system according to independent claim 1 or by a plasma process system according to independent claim 10. Advantageous further embodiments result from the subclaims and/or the description.

In accordance with the present invention, a method of operating a plasma process system is proposed where the plasma process system comprises:
a) a plasma process chamber with a plasma process chamber wall being connected to an electrical potential, e. g. ground,
b) a HiPIMS power supply designed for supplying high voltage and high power pulses, in particular with a voltage equal or larger than 300 V, preferred equal or larger than 800 V, in particular with a power of the pulses equal or larger than 10 kW, especially equal or larger than 100 kW, preferred equal or larger than 1.000 kW, in particular with a duration of the pulse equal or shorter than 500 µs, preferably not longer than 300 µs, more preferably not longer than 100 µs, especially not longer than 20 µs, in particular with a repetition time of 200 µs to 1 s, where the repetition time is at least by the factor 5 larger than the pulse duration time,
c) an electrode inside the plasma chamber connected to the HiPIMS power supply,
the method of operating a plasma process system comprising the steps:
i. the HiPIMS power supply supplying pulses of high voltage with a first potential, in particular with negative potential, in relation to the plasma process chamber wall with a pulse-on time duration to the electrode, and
ii. disconnect the HiPIMS power supply after the pulses for a pulse-off time duration, and
iii. connect the electrode to a second potential opposite of the first potential, in particular to a positive potential, in relation to the plasma process chamber wall immediately before the pulses of high voltage with first potential start.

This can provide a method of operating a plasma process system that can prevent or at least mitigate the accumulation of charged particles on the target of the plasma process system. Thereby, the damaging arcing can be mitigated.

The pulses of high voltage with a first potential, in particular with negative potential, in relation to the plasma process chamber may have preferably a pulse-on time duration which is much shorter than the pulse-off-time duration. In particular the pulse-on time duration is at least by a factor f smaller than the pulse-off-time duration with f = 5, in particular 10, preferred 20.

It is important that the electrode is connected to the second potential immediately before the pulses of high voltage with first potential start. With 'immediately' is meant that the time duration between the end of the second potential and the start of the pulses with first potential is predefined in a way to be as short as technically reasonable. As it is clear that the first potential has a high energy and could damage a power supply providing the second potential, this power supply delivering the second potential must be disconnected or at least protected before the pulse with the first potential starts. On the other hand, the time duration between the end of the second potential and the start of the pulses with first potential should not be so long as to allow particles on the electrode to charge up again. So, as this depends also to geometry of the plasma chamber and electrode configuration, time durations ≤ 1 ms, especially ≤ 100 µs have been ound to be reasonable.

Moreover, in the method of operating a plasma process system the electrode of the plasma process system can be connected the entire pulse off time to a positive potential in relation to the plasma process chamber. The connected potential can be a constant potential. The positive potential in the entire pulse off time does not allow the accumulation of positively charged particles on the electrode and thus prevents arcing at the beginning of a HiPIMS pulse with negative potential.

The positive potential can also be connected in short pulses. These pulses with positive potential can have a ramping pattern, e. g. linear slope or staircase-shaped. Further these pulses can have different lengths. The pulses with positive potential immediately before the HiPIMS pulses with negative potential can remove positively charged particles from the electrode and thus prevents arcing at the beginning of a HiPIMS pulse with negative potential.

In one aspect, the method of operating a plasma process system comprises the step of using an electrical low or especially non conducting target. It was found that especially due to high voltage and high discharge current HIPIMS operation on non conducting target is challenging due to accumulation of a charge-up on the target. With electrical low conducting target is meant a target with a high resistance per area, e.g. ≥ 100 Ω /cm²

In addition, in the method of operating a plasma process system the electrode of the plasma process system can be a target acting as cathode of HiPIMS power supply. The target can be a solid state that is suitable as an electrode and also contains the material with which, for example, the substrate is to be coated. The combination of target and electrode results in an uncomplicated setup of the plasma process system.

Furthermore, in the method of operating a plasma process system a substrate to be processed in the plasma process chamber can also be connected to the HiPIMS power supply. The substrate can also be connected to a second power supply or to both, the HiPIMS power supply and a second power supply. The substrate can also be connected only to a second power supply. The second power supply can also be a HiPIMS power supply or a conventional dc power supply, which does not supply pulses but a constant voltage.

If the substrate is connected to the HiPIMS power supply, the same voltage is applied between the substrate and the wall of the plasma process chamber as is applied between the electrode and the wall of the plasma process chamber . In this use, however, this voltage between the substrate and the wall of the plasma process chamber is not used for plasma generation, but as a so-called bias voltage.

In case the HiPIMS power supply and a second power supply are connected to the substrate, switches can be used, for example, by which the HiPIMS power supply or the second power supply can be switched on and off. This allows the voltage provided by the HiPIMS power supply or the second power supply to be switched on and off. The switches can be, for example, semiconductor switching elements such as metal oxide semiconductor field-effect transistors (MOSFETS). If only a second power supply is connected to the substrate, a bias voltage can be supplied to the plasma process system via this second power supply.

Moreover, the method of operating a plasma process system can be used whenever the plasma process system has a suitable HiPIMS power supply. This makes the method of operating a plasma process system according to the invention very widely applicable.

In one aspect the method comprises a step of delivering power to a second electrode in the plasma chamber by a power supply which is different from the HIPIMS power supply.

With 'different' is meant here that the power supply is not of the same type, so it does not deliver HIPIMS pulses. It could be a pulsed DC power supply delivering low energy pulses to the second electrode. It could be a DC power supply delivering continuous DC power to the second electrode. It could be a MF power supply delivering bipolar rectangular or bipolar sinuous MF power, e.g., with a frequency in the range of 1 kHz to 500 kHz, to the second electrode. It could be a HF power supply delivering HF power, e.g., with a frequency in the range of 1 MHz to 200 MHz, to the second electrode.

The plasma process system according to the invention for executing the method of operating a plasma process system comprises a plasma process chamber with a plasma process chamber wall, a HiPIMS power supply and an electrode.

The plasma process chamber wall is connected to an electrical potential, e. g. ground. The HiPIMS power supply is designed for the provision of high-voltage and high-power pulses. The electrode is connected to the HiPIMS power supply. The electrode is located in the plasma process chamber and the pulses from the HiPIMS power supply enter the plasma process chamber via it. The electrode can be a target acting as the cathode of the HiPIMS power supply.

In an advantageous further embodiment, the plasma process system may have more than one electrode. This allows, for example, a coated substrate to have a higher wear resistance than a coated substrate in a plasma process system with a single electrode.

In one aspect the problem may be solved by a plasma process system, comprising:
a) a plasma process chamber with a plasma process chamber wall being connected to an electrical potential, e. g. ground,
b) a HiPIMS power supply designed for supplying high voltage high power pulses,
c) an electrode inside the plasma chamber connected to the HiPIMS power supply, and
the plasma process system is configured to perform the following steps:
i. the HiPIMS power supply supplying pulses of high voltage with a first potential, in particular a negative potential, in relation to the plasma process chamber wall to the electrode, and is disconnected in pulse off times,
ii. the electrode is connected to a second potential opposite of the first potential, in particular a positive potential, in relation to the plasma process chamber wall immediately before the pulses of high voltage with first potential.

In one aspect the plasma process system comprises a second electrode. This second electrode may be connected to a power supply which is different from the HIPIMS power supply.

With 'different' is meant here that the power supply is not of the same type, so it is no HIPIMS power supply as it is explained earlier in this disclosure.

Additional objects and advantages of the invention will be set forth in the description which follows and will be obvious from the description. The objects and advantages of the invention may be realized and obtained by means of a method, processes, instrumentalities, and combinations, particularly pointed out in the claims.

A detailed description of non-limiting embodiments is presented hereinbelow with reference to the accompanying drawings, in which:
- Fig. 1: is a first embodiment of a plasma process system,
- Fig. 2: is a second embodiment of a plasma process system,
- Fig. 3-7: are voltage characteristics of the cathode voltage for the method of operating a plasma process system.

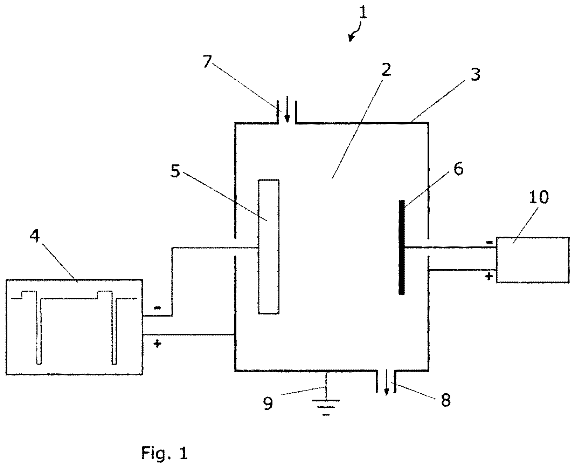

Fig. 1 shows one possible embodiment of a plasma process system 1 for the method of operating a plasma process system according to the invention. The plasma process system 1 comprises a HiPIMS power supply 4, a plasma process chamber 2, and a second power supply 10. This plasma process chamber 2 includes a wall 3, a gas inlet 7, a gas outlet 8, an electrode 5 and a substrate 6.

The wall 3 of the plasma process chamber 2 is connected to ground potential 9. In this case the wall 3 of the plasma process chamber 2 forms the anode of the HiPIMS power supply 4 and of the second power supply 10.

Sputtering and reactive gas required for plasma generation can be admitted via the gas inlet 7. The sputtering gas can be argon, for example. The reactive gas can be nitrogen, for example. The gas outlet 10 is designed to create a vacuum in the plasma process chamber 2. The gas outlet 10 can also have other components for vacuum generation, such as a pump and valves. Vacuum here means a space with extensive absence of matter.

The electrode 5 is implemented in form of a target and is connected to the negative potential of the HiPIMS power supply 4 and thus forms the cathode of the HiPIMS power supply 4.

The cathode voltage is applied between the electrode 5 and the wall 3 of the plasma process chamber 2.

The bias voltage can be applied via a second power supply 10. This second power supply 10 is also connected to the substrate 6. The second power supply 10 can also be a HiPIMS power supply or a conventional dc power supply, which does not supply pulses but a constant voltage.

Plasma is generated within the plasma process chamber 2, which is used, for example, to coat the substrate 6.

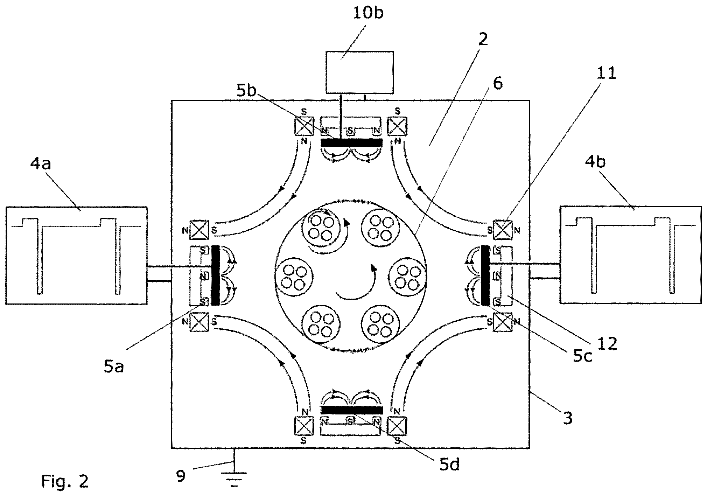

Fig. 2 shows a second embodiment of a plasma process system 1 for the method of operating a plasma process system according to the invention. The plasma process system 1 comprises also a plasma process chamber 2 with a wall 3 connected to ground 9. This plasma process chamber 2 includes also a gas inlet (not shown), a gas outlet (not shown), and a substrate 6. The substrate 6 is here build as an in several directions rotatable tool holder, where the tools are to be covered with the plasma process. This plasma process chamber 2 comprises four electrodes 5a - 5d acting as cathodes and targets. Several magnets 11, 12 are placed behind the electrodes 5a-5d, all marked with their poles N and S. Those magnets are used to enhance the ionization process and could also be placed in the plasma chamber of Fig. 1. Two HiPIMS power supplies 4a, 4b, are connected to two electrodes 5a, 5c, respectively. A third electrode 5b is connected to a different power supply 10b. A fourth electrode 5d may connected to a further power supply (not shown) which may be also different. With 'different' is meant here that the power supply is not of the same type as the HIPIMS power supply 4a, 4b as it is explained earlier in this disclosure.

Other possible embodiments of a plasma process system with a HiPIMS power supply are shown in the following publications, e.g.: WO 2013/000918 A1, US 2010/0025230 A1.

A HiPIMS power supply may be designed for the provision of pulses with a voltage equal or larger than 300 V, preferred equal or larger than 800 V.

A HiPIMS power supply may be designed for the provision of pulses with a power of the pulses equal or larger than 10 kW, especially equal or larger than 100 kW, preferred equal or larger than 1.000 kW.

A HiPIMS power supply may be designed for the provision of pulses with a duration of the pulse equal or shorter than 500 µs, preferably not longer than 300 µs, more preferably not longer than 100 µs, especially not longer than 20 µs, in particular with a repetition time of 200 µs to 1 s, where the repetition time is at least by the factor 5 larger than the pulse duration time.

A HiPIMS power supply may be designed for the provision of pulses with an energy of at least 10 J.

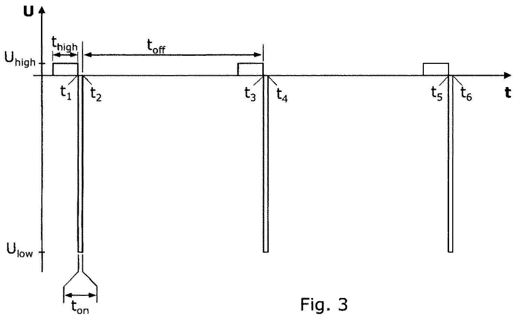

Fig. 3 to 7 show possible voltage characteristics of the cathode voltage for the method of operating a plasma process system according to the invention in diagrams, where the voltage U is shown over the time t. With "cathode voltage" is meant here the pulses provided by the HiPIMS power supply 4. The characteristic short pulses with a first potential, in particular here with the high negative voltage, have the same pulse-on duration time tₒₙ in all figures. After a pulse off time t_{off}, the next pulse with high negative voltage starts. So, these pulses of high voltage with a first potential have a repetition time duration which is the sum of this pulse-on duration time tₒₙ and the pulse-off time duration t_{off}. The pulses with the second, in particular with the positive voltage according to the invention differ during the pulse off time t_{off} from Fig 3 to Fig. 6.

During the characteristic short negative pulses, the HiPIMS power supply 4 provides the cathode voltage U_{low}. Such a pulse starts at times t₁, t₃, t₅ and ends at times t₂, t₄, t₆, and has a duration of tₒₙ. Following the end of the pulses at the times t₂, t₄, t₆, the pulse-off time duration t_{off} starts, during which the HiPIMS power supply 4 does not supply pulses with high negative voltage. A HiPIMS power supply 4 is usually realized by one or more energy storages, such as one or more big capacitors, which are loaded to a high energy level, and e.g. a high voltage, during the pulse-off time duration t_{off} and are discharged during the pulse-on time duration tₒₙ by switching elements. So, during the pulse-off time duration t_{off}, the electrode 5 is not connected to any potential and is therefore floating. It was found that such a floating electrode 5 tends to attract particles, ions, and/or atoms being present in the plasma chamber. These particles, ions, and/or atoms could lead to an insulating or at least bad conducting surface on the electrode or nearby. It was further found that with the start of one of the following pulses, such a surface may charge up or even been charged up by other comparable continuous plasma processes in the chamber. Such charge ups could lead to a higher arc-rate which is undesirable.

During the pulse off time t_{off}, the HiPIMS power supply 4 according to the invention may provide a pulse with a second potential opposite of the first potential, in particular in the form of a positive cathode voltage. This pulse with the second potential may differ in shape and length and may prevent the accumulation of charged particles on the target, whereby the arcing can be mitigated.

It is important, that the pulses with the second potential opposite of the first potential are immediately before the pulses with the first potential. With 'immediately' is meant that the time duration between the end of the second potential and the start of the pulses with first potential is predefined in a way to be as short as technically reasonable. As it is mentioned earlier, it is clear that the first potential has a high energy and could damage a power supply providing the second potential. This power supply providing the second potential must therefore be disconnected or at least protected before the pulse with the first potential starts. This needs at least some time. On the other hand, the time duration between the end of the second potential and the start of the pulses with first potential should not be so long as to allow particles on the electrode 5 to charge up again. So, as this depends also to geometry of the plasma chamber 2 and electrode 5 configuration, time durations ≤ 1 ms, especially ≤ 100 µs have been found to be reasonable.

As can be seen in Fig. 3 to 6, the pulses of high voltage with a first potential, in particular with negative potential, in relation to the plasma process chamber may have preferably a pulse-on time duration tₒₙ which is much shorter than the pulse-off-time duration t_{off},. In particular, the pulse-on time duration is at least by a factor f smaller than the pulse-off-time duration with f = 5, in particular 10, preferred 20.

In Fig. 3, this positive pulse has a rectangular shape of length t_{high} and the HiPIMS power supply 4 provides the cathode voltage U_{high} throughout the whole pulse. The positive pulse is applied immediately before the pulse with high negative voltage.

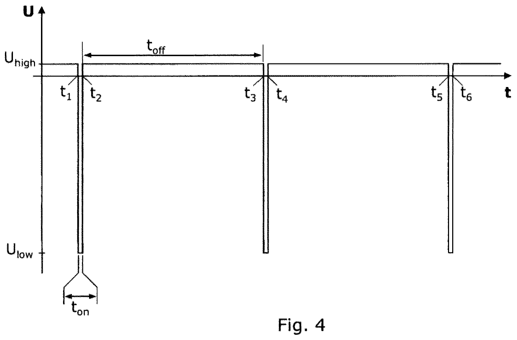

In Fig. 4, the HiPIMS power supply 4 provides the positive cathode voltage U_{high} throughout the whole pulse-off time t_{off}.

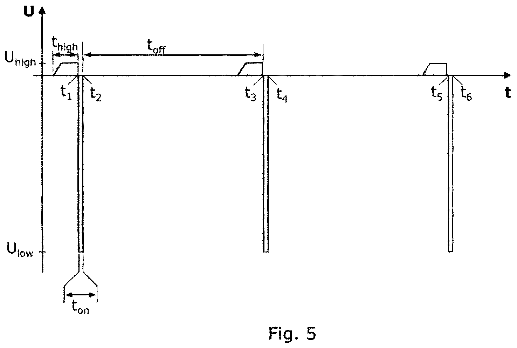

In Fig. 5, the positive pulse has a ramping pattern and a length of t_{high}. The positive pulse is located before the negative pulse at the end of the pulse off time t_{off}. The positive pulse increases linearly to the cathode voltage U_{high}. After reaching this cathode voltage U_{high}, it is kept constant until the end of the pulse-off time t_{off}.

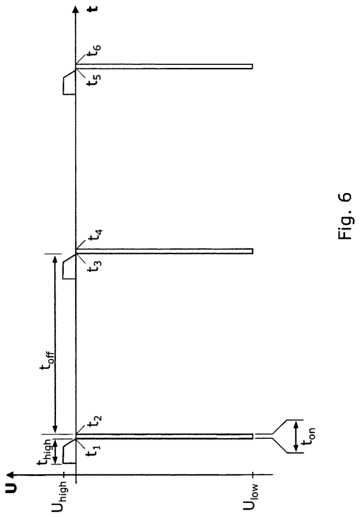

Fig. 6 is very similar to Fig. 5 except that here the positive pulse starts at the cathode voltage U_{high}, keeps it constant for a predefined time, and then decreases linearly to the end of the pulse-off time t_{off}.

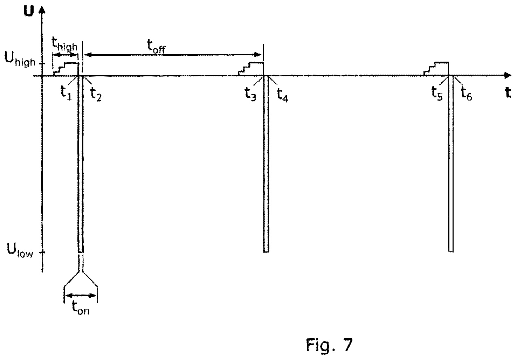

Fig. 7 is again very similar to Fig. 5 except that the positive pulse here does not rise linearly but in a staircase-shape.

In addition to the pulse shapes shown, other pulse shapes or combinations of pulse shapes may also be possible for the cathode voltage.

## Claims

1. Method of operating a plasma process system (1),
the plasma process system (1) comprises:
a) a plasma process chamber (2) with a plasma process chamber wall (3) being connected to an electrical potential, in particular ground (9),
b) a HiPIMS power supply (4, 4a, 4b) designed for supplying high voltage high power pulses,
c) an electrode (5, 5a, 5c) inside the plasma chamber (2) connected to the HiPIMS power supply (4, 4a, 4b),
the method of operating a plasma process system (1) comprising the steps:
i. the HiPIMS power supply (4, 4a, 4b) supplying pulses of high voltage with a first potential, in particular a negative potential in relation to the plasma process chamber wall (3) with a pulse-on time duration (tₒₙ) to the electrode (5, 5a, 5c), and
ii. disconnect the HiPIMS power supply (4, 4a, 4b) after the pulses for a pulse-off time duration (t_{off}), and
iii. connect the electrode (5, 5a, 5c) to a second potential opposite of the first potential, in particular a positive potential, in relation to the plasma process chamber wall (3) immediately before the pulses of high voltage with first potential start.

2. Method of operating a plasma process system (1) according to claim 1, whereby the electrode is connected the entire pulse-off time (t_{off}) to a second potential in relation to the plasma process chamber wall (3).

3. Method of operating a plasma process system (1) according to claim 1, whereby the second positive potential is connected as pulses which are shorter than the pulse-off time duration (t_{off}) to the electrode (5, 5a, 5c).

4. Method of operating a plasma process system (1) according to claim 3, whereby the pulses with second potential have a ramping pattern, e. g. linear slope or staircase-shaped.

5. Method of operating a plasma process system (1) according to any of the preceding claims, whereby the electrode of the plasma process system (1) is a target acting as cathode, and the target is in particular a low or especially non conducting target.

6. Method of operating a plasma process system (1) according to any of the preceding claims, whereby a substrate (6) to be processed is also connected to the HiPIMS power supply (4) or/and second power supply (10).

7. Method of operating a plasma process system (1) according to any of the preceding claims whereby the plasma process system (1) comprises and/or uses a HiPIMS power supply (4, 4a, 4b).

8. Plasma process system (1) arranged for executing the method steps of claim 1, comprising:
a) a plasma process chamber (2) with a plasma process chamber wall (3) being connected to an electrical potential, e. g. ground,
b) a HiPIMS power supply (4, 4a, 4b) designed for the provision of high voltage high power pulses,
c) an electrode connected to the HiPIMS power supply (4, 4a, 4b).

9. Plasma process system (1) according to claim 8, whereby the plasma process system (1) comprises a second electrode (5b).

10. Plasma process system (1), according to any of the preceding claims 8 or 9, whereby the second electrode is connected to a power supply (10b) which is different from the HIPIMS power supply (4, 4a, 4b).
